# EUROPÄISCHE PATENTSCHRIFT

(11) **EP 2 633 626 B1**
(45) Veröffentlichungstag und Bekanntmachung des Hinweises auf die Patenterteilung: **25.01.2023**
(21) Anmeldenummer: 11757226.3
(22) Anmeldetag: 01.09.2011
(51) Int. Cl.: H03M 9/00, H04L 25/02, H03L 7/197

(54) **ÜBERTRAGUNGSVERFAHREN UND -SYSTEM**
TRANSMISSION METHOD AND SYSTEM
PROCÉDÉ ET SYSTÈME DE TRANSFERT

(30) Priorität: 26.10.2010 DE 102010042903
(43) Veröffentlichungstag der Anmeldung: 04.09.2013
(73) Patentinhaber: Robert Bosch GmbH, 70442 Stuttgart (DE)
(72) Erfinder: HIMMELSTOSS, Armin, 71554 Weissach Im Tal (DE)
(86) Internationale Anmeldenummer: PCT/EP2011/065102
(87) Internationale Veröffentlichungsnummer: WO 2012/055615

(56) Entgegenhaltungen:
- JP-A- 60 049 432
- US-A- 3 855 617
- US-A- 4 751 699
- US-A1- 2005 069 019
- US-A1- 2009 083 567

## Beschreibung

Die Erfindung betrifft ein Übertragungsverfahren zum Übertragen digitaler Daten über eine Leitung. Ferner betrifft die Erfindung ein System zur Übertragung digitaler Daten über eine Leitung und einen Radarsensor.

### Stand der Technik

Bei der Übertragung digitaler Daten über eine Leitung können elektromagnetische Störungen im Bereich der Leitung entstehen, die zu einer Übertragungsgeschwindigkeit der Daten proportional sind. Grundsätzlich gilt, dass bei steigenden Datenübertragungsraten auch Störsignale höherer Frequenzen erzeugt werden. Konventionelle Maßnahmen zur Unterdrückung solcher Störungen umfassen Abschirmungen und Masseflächen. Da hochfrequente Signale eher zu einem Abstrahlen von der Leitung tendieren, ist mit steigender Frequenz der Störungen auch ein zu betreibender Aufwand zu deren Unterdrückung größer. Die Störungen können als elektromagnetische Wellen von der Leitung abgestrahlt werden oder sich entlang der Leitung fortpflanzen.

Um einen Verbindungsaufwand zwischen einem Sender und einem Empfänger zu reduzieren, ist es vielerorts üblich, eine serielle Übertragung der digitalen Daten über die Leitung vorzunehmen. Bei gleicher Übertragungsrate muss eine serielle Schnittstelle schneller, also mit höheren Frequenzen als eine parallele Schnittstelle betrieben werden, sodass eine Neigung zur Abstrahlung von Störsignalen an seriellen Schnittstellen grundsätzlich erhöht ist. Typische serielle Protokolle und Busse sind SPI, I2C, USB, RS232, RS45 und LVDS. Bei einigen dieser Protokolle bzw. Busse wird eine differenzielle Übertragung von Signalen entlang des Leiters gewählt, was den Leitungsaufwand verdoppelt, aber auch die Störsicherheit erhöht und die Abstrahlung von Störsignalen reduziert. Alle aufgeführten Protokolle bzw. Busse verwenden eine fest vorbestimmte Datenübertragungsfrequenz. Abgestrahlte Störsignale sind daher nur in einem vorherbestimmbaren, von der Datenübertragungsrate abhängigen Frequenzband zu erwarten.

Die beschriebenen Störungen können auch bei der Übertragung von Messwerten von einem Sensor an eine Steuerungskomponente auftreten. Beispielsweise im Umfeld von Kraftfahrzeugen kann ein Sensor zusammen mit einer Vielzahl potentieller elektromagnetischer Störquellen in einem weit verzweigten und komplexen Leitungsnetz eingesetzt werden. Eine Abstrahlarmut von Störungen entlang bzw. von der Leitung und eine Resistenz gegen Einstrahlungen von elektromagnetischen Störungen über die Leitung sind in einem derartigen Umfeld üblicherweise per Lastenheft definiert.

US 3 855 617 A betrifft ein System zur Abtastung und Übertragung digitaler und analoger Signale zu einer entfernten Datenverarbeitungseinrichtung.

US 2009/083567 A1 betrifft eine Vorrichtung und ein Verfahren zur Bereitstellung eines Taktsignals auf der Basis stückweise linearer Modulation.

US 2005/069019 A1 betrifft einen digitalen Taktgenerator mit variabler Frequenz.

Der Erfindung liegt die Aufgabe zugrunde, ein Verfahren und ein System zur Übertragung digitaler Daten über eine Leitung bereitzustellen, welche bei geringem Aufwand verbesserte Störeigenschaften aufweisen.

Die Erfindung löst diese Aufgabe durch ein Verfahren, durch einen Radarsensorund durch ein System mit den Merkmalen der unabhängigen Patentansprüche. Unteransprüche gegeben bevorzugte Ausführungsformen an.

### Offenbarung der Erfindung

Ein erfindungsgemäßes Verfahren zum Übertragen digitaler Daten eines Radarsensors über eine Leitung umfasst Schritte des Bereitstellens eines Taktsignals, Weiterleiten des Taktsignals an einen Ausgangsverstärker, Verstärkung des Taktsignals und Abstrahlung des verstärkten Signals über eine Sendeantenne, Empfang einer Reflexion des abgestrahlten Signals mittels einer Empfangsantenne, Verstärken der empfangenen Reflexion mittels eines Empfangsverstärkers, Bilden einer Differenz zwischen dem Taktsignal und dem verstärkten empfangenen Signal mittels eines Differenzbildners, Abtastung der durch den Differenzbildner bereitgestellten Differenz mittels eines Analog-Digital-Wandlers und des Übertragens der digitalen Daten synchron zum Taktsignal, wobei das Taktsignal eine Frequenz aufweist, die über die Zeit veränderlich ist.

Ein Frequenzband, auf dem elektromagnetische Störungen abgestrahlt bzw. empfangen werden können, wird auf diese Weise verbreitert. Die jeweilige Energie pro Frequenz wird dadurch verringert, so dass die Resistenz gegenüber Störungen und die Abstrahlung von Störungen pro Frequenz verringert ist. Vorteilhafterweise kann das verbesserte Störverhalten relativ einfach erreicht werden.

Vorzugsweise wird die Frequenz abschnittweise linear verändert. Eine derartige Frequenzmodulation ist leicht herzustellen und kann einen vereinfachten Aufbau der Übertragung zwischen einem Sender und einem Empfänger der digitalen Daten erlauben. Die digitalen Daten können binär kodiert und seriell übertragen werden. Dadurch ist das Verfahren besonders geeignet für eine serielle Datenübertragung, für die eine wenig aufwendige Leitung verwendet werden kann.

Ein erfindungsgemäßer Radarsensor weist eine Sendereinrichtung, eine Modulationsquelle, einen modulierbaren Oszillator, einen Teiler, einen Ausgangsverstärker, eine Sendeantenne, eine Empfangsantenne, einen Empfangsverstärker, einen Differenzbildner sowie einen Analog-Digital-Wandler auf und ist eingerichtet, das erfindungsgemäße Verfahren durchzuführen.

Ein erfindungsgemäßes System zur Übertragung digitaler Daten umfasst einen erfindungsgemäßen Radarsensor mit einer Sendeeinrichtung, eine Empfangseinrichtung und eine Leitung zur Übertragung eines Leitungssignals von der Sendeeinrichtung zur Empfangseinrichtung. Die Sendeeinrichtung umfasst einen Taktgenerator zur Bereitstellung eines über die Zeit veränderlichen Taktsignals und eine Synchronisiereinrichtung zur Bereitstellung des Leitungssignals auf der Basis einer Synchronisierung der Daten mit dem Taktsignal. Die Empfangseinrichtung umfasst eine Dekodiereinrichtung zur Dekodierung der Daten aus dem über die Leitung übertragenen Leitungssignal.

Vorteilhafterweise kann das erfindungsgemäße System insbesondere in Umfeldern eingesetzt werden, in denen eine Abstrahlung elektromagnetischer Signale von der Leitung und eine Anfälligkeit gegenüber elektromagnetischen Einstrahlungen über die Leitung kritische Faktoren sind. Dabei kann die Leitung unterschiedliche Länge haben und beispielsweise durch ein Kabel oder durch eine Leiterbahn auf einer Platine gebildet sein. Die erfindungsgemäße Variation des Taktsignals, auf dessen Basis die Daten über die Leitung übermittelt werden, kann auf einfache und kostengünstige Weise implementiert werden. Dadurch eignet sich das System auch für Einrichtungen, in denen eine Vielzahl von Datenübertragungen vorgesehen sind.

Vorzugsweise weist die Leitung nur einen physischen Kanal zum Übertragen von Informationen auf. Auf eine Übertragung des Taktsignals kann verzichtet werden. Dadurch können Herstellungskosten für das System gering gehalten sein. In einer alternativen Ausführungsform kann das Taktsignal auch mittels eines separaten physischen Kanals übertragen werden, wodurch eine verbesserte Decodierung seitens der Empfangseinrichtung erzielt werden kann.

Die Synchronisiereinrichtung kann eine Umwandlungseinrichtung paralleler in serielle digitale Daten umfassen. So kann die Umwandlung parallel vorliegender Daten in eine über die Leitung übertragbare Form gleichzeitig mit der Synchronisierung auf das Taktsignal variabler Frequenz durchgeführt werden. Die Synchronisiereinrichtung kann auf einfache Weise beispielsweise mittels eines Schieberegisters aufgebaut sein.

Die Sendeeinrichtung kann eine Abtasteinrichtung zur Abtastung einer Messgröße umfassen, wobei die digitalen Daten durch die Abtastung bereitgestellte Messwerte repräsentieren.

So ist es möglich, die Sendeeinrichtung mit einem Sensor zu integrieren, sodass ein einfacher und kostengünstiger digitaler Sensor bereitgestellt werden kann, der in dem oben beschriebenen System mit gutem Störverhalten betreibbar ist.

Dabei kann ein vom Taktgenerator unabhängiger Taktgeber zur Generierung eines Abtastsignals mit konstanter Frequenz zur Steuerung der Abtasteinrichtung vorgesehen sein. Die Abtastung der Messgröße kann auf diese Weise auf der Basis eines festen Zeitrasters erfolgen, während die Übertragung der Daten, welche die Messwerte repräsentieren, auf der Basis des variablen Taktsignals erfolgen kann. Das beschriebene System lässt sich auf diese Weise gut in ein bestehendes System integrieren, welches die abgetasteten Messwerte weiterverarbeitet.

Insbesondere kann die Sendeeinrichtung einen Radarsensor umfassen. Eine störungsgesicherte Übertragung der mittels des Radarsensors erhobenen Messwerte kann mittels des beschriebenen Systems einfach und zuverlässig erfolgen.

Die Empfangseinrichtung kann einen programmierbaren Mikrocomputer umfassen.

### Kurze Beschreibung der Figuren

Die Erfindung wird nun mit Bezug auf die beigefügten Figuren näher beschrieben, in denen:
Figur 1 ein System zur Übertragung digitaler Daten über eine Leitung;
Figur 2 eine weitere Ausführungsform des Systems von Figur 1 als Teil eines Radarsensors; und
Figur 3 ein Ablaufdiagramm eines Verfahrens zur Übertragung digitaler Daten über eine Leitung;
   darstellt.

### Genaue Beschreibung von Ausführungsbeispielen

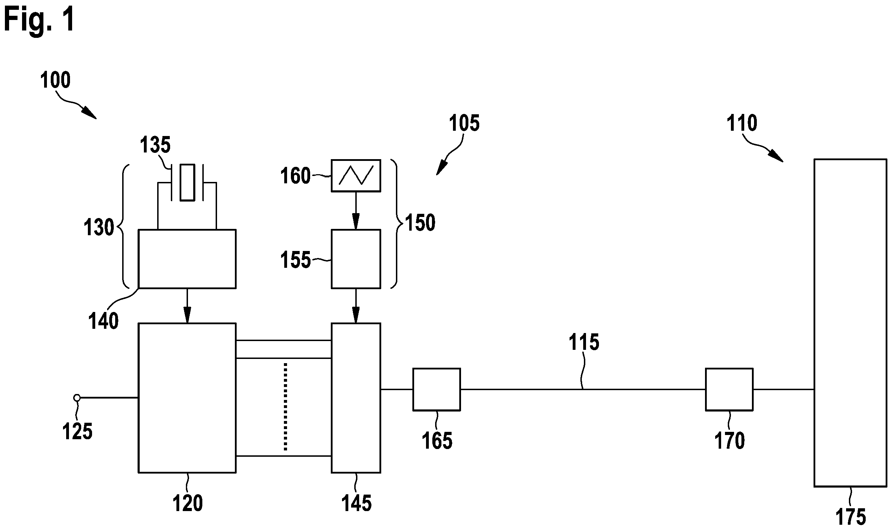

Figur 1 zeigt ein System 100 zur Übertragung digitaler Daten über eine Leitung.

Das System 100 umfasst eine Sendeeinrichtung 105, eine Empfangseinrichtung 110 und eine Leitung 115, mittels derer die Sendeeinrichtung mit der Empfangseinrichtung verbunden ist.

Die Sendeeinrichtung 105 umfasst einen Analog-Digital-Wandler 120 zur Abtastung einer Messgröße, die an einem Anschluss 125 anliegt, welcher mit dem Analog-Digital-Wandler 120 verbunden ist. Der Analog-Digital-Wandler 120 arbeitet auf der Basis eines Taktsignals, welches von einem Taktgeber 130 bereitgestellt ist. Der Taktgeber 130 umfasst einen Schwingquarz 135 und einen Teiler 140. In anderen Ausführungsformen kann der Taktgeber 130 auch beispielsweise auf der Basis eines keramischen Oszillators, eines RC-Glieds oder eines LC-Glieds aufgebaut sein. Auf jeden Fall ist das vom Taktgeber bereitgestellte Abtastsignal von einer konstanten Frequenz über die Zeit, so dass der Analog-Digital-Wandler 120 in konstanten Abständen Messwerte zur Verfügung stellt.

Mit dem Anschluss 125 kann ein beliebiger Sensor verbunden sein, beispielsweise ein Bedienelement oder Messdatenfühler einer Motorsteuerung, einer Klimaanlage, eines Sicherheitssystems, einer Navigationsvorrichtung, eines Reifendruck-Überwachungssystems oder einer anderen Steuereinrichtung an Bord eines Kraftfahrzeugs. Der Sensor kann mit der Sendeeinrichtung 105 integriert ausgeführt sein. Die am Anschluss 125 anliegenden Werte können später vom programmierbaren Mikrocomputer 175 weiterverarbeitet werden, etwa in Form einer Steuerung oder Regelung.

Der Analog-Digital-Wandler 120 stellt den abgetasteten digitalen Wert in binär kodierter Form auf mehreren Leitungen einem Schieberegister 145 bereit. Das Schieberegister 145 übernimmt die bereitgestellten parallelen Daten und wandelt sie auf der Basis eines Taktsignals in serielle Daten um.

Das Taktsignal für das Schieberegister 145 wird von einem Taktgenerator 150 bereitgestellt, der einen modulierbaren Oszillator 155 und eine Modulationsquelle 160 umfasst. Der modulierbare Oszillator 155 ist ein spannungsgesteuerter Oszillator (Voltage Controlled Oscilator, VCO) und die Modulationsquelle 160 stellt ein abschnittsweise lineares Modulationssignal bereit. Das bereitgestellte Modulationssignal kann beispielsweise die Form eines Dreiecks, eines Sägezahns oder eines Trapezes haben. Dementsprechend ist die Frequenz des vom modulierbaren Oszillator 155 bereitgestellten Taktsignals über die Zeit abschnittsweise linear veränderlich.

Die mittels des Schieberegisters 145 serialisierten Daten werden mittels eines Treibers 165 auf die Leitung 115 gelegt.

Die Leitung 115 ist vorzugsweise eine Zweidrahtleitung, wobei sowohl ein asymmetrischer (single ended) als auch ein symmetrischer (differential) Aufbau verwendet werden kann. Ein zusätzlicher Draht bzw. ein zusätzliches Drahtpaar kann zur Übermittlung des variablen Taktsignals vorgesehen sein. Die Leitung 115 kann etwa koaxial, parallel oder verdrillt ausgeführt sein. Zusätzlich können eine oder mehrere Abschirmungen im Bereich der Leitung 115 angeordnet sein. In noch einer Ausführungsform überträgt die Leitung 115 ein durch den Treiber 165 bereitgestelltes differenzielles Signal, wobei die Leitung 115 eine Drei- oder Mehrdrahtleitung ist.

Das mittels der Leitung 115 übertragene Leitungssignal wird seitens der Empfangseinrichtung 110 durch einen weiteren Treiber 170 terminiert. Die Treiber 165 und 170 korrespondieren zueinander und definieren physikalische Übertragungsparameter über die Leitung 115 wie beispielsweise eine Übertragungsspannung, einen differenziellen Betrieb und eine Impedanz der Leitung 115. Das durch den weiteren Treiber 170 gewandelte Leitungssignal wird an einen programmierbaren Mikrocomputer 175 weitergeleitet, der daraus die übermittelten Daten rekonstruiert. In einer bevorzugten Ausführungsform ist der Mikrocomputer 175 dazu eingerichtet, die rekonstruierten Daten weiterzuverarbeiten. Zur Weiterverarbeitung kann eine Manipulation, Zusammenfassung, Speicherung und/oder Weiterleitung der Daten gehören.

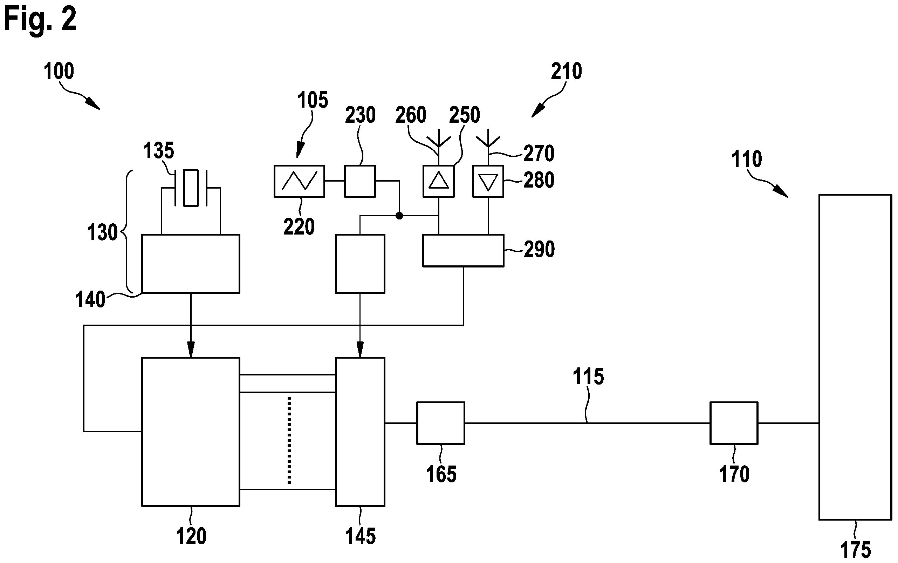

Figur 2 zeigt eine weitere Ausführungsform des Systems 100 von Figur 1 als Teil eines Radarsensors 210. Im Unterschied zu der oben mit Bezug auf Figur 1 beschriebenen Ausführungsform erfolgt die Bereitstellung des Taktsignals für das Schieberegister 145 auf eine andere Art und Weise und der Analog-Digital-Wandler 120 tastet ein Signal ab, dass von einem Element des Radarsensors 210 bereitgestellt wird.

Der Radarsensor 210 umfasst eine Modulationsquelle 220, die im Wesentlichen der oben beschriebenen Modulationsquelle 160 entspricht. Die Modulationsquelle 220 stellt ein Modulationssignal an einen modulierbaren Oszillator 230 bereit.

Wie oben mit Bezug auf den modulierbaren Oszillator 155 von Figur 1 beschrieben ist, stellt der modulierbare Oszillator 230 ein entsprechend dem Modulationssignal moduliertes Taktsignal bereit. Das Taktsignal wird mittels eines Teilers 240 durch eine vorbestimmte Konstante geteilt, die in einer bevorzugten Ausführungsform eine Zweierpotenz ist, sodass der Teiler 240 leicht beispielsweise als Kaskade von Flipflops aufgebaut sein kann.

Das Taktsignal wird ferner an einen Ausgangsverstärker 250 weitergeleitet, der das Signal verstärkt und über eine Sendeantenne 260 abstrahlt. Eine Reflexion des abgestrahlten Signals von einem Objekt wird mittels einer Empfangsantenne 270 empfangen und mittels eines Empfangsverstärkers 280 verstärkt. Ein Differenzbilder 290 bildet eine Differenz zwischen dem Taktsignal und dem verstärkten empfangenen Signal.

Ohne näher auf den Radarsensor 210 und seine Variationsmöglichkeiten einzugehen, ist die durch den Differenzbilder 290 bereitgestellte Differenz proportional zu einer Relativgeschwindigkeit bzw. einem Abstand eines Objekts, welches das mittels der Sendeantenne 260 ausgesandte Signal zur Empfangsantenne 270 reflektiert, zu den Antennen 260 und 270. Die vom Differenzbilder 290 bereitgestellte Differenz wird, wie oben beschrieben, mittels des Analog-Digital-Wandlers 120 abgetastet. Die Übertragung der abgetasteten Werte über die Leitung 115 erfolgt wie oben mit Bezug auf Figur 1 ausgeführt ist.

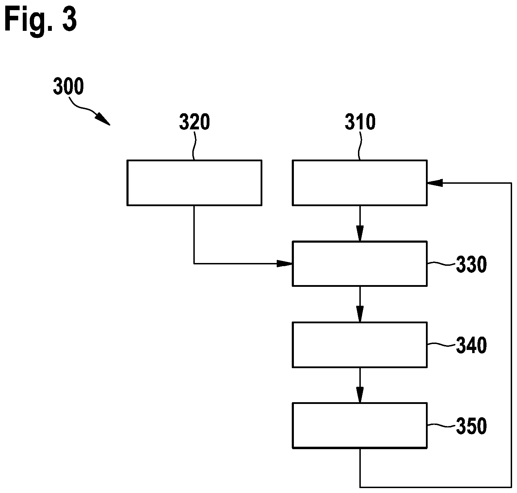

Figur 3 zeigt ein Ablaufdiagramm eines Verfahrens 300 zur Übertragung digitaler Daten über eine Leitung. Das Verfahren 300 ist insbesondere zur Ausführung durch die Systeme 100 der Figuren 1 und 2 geeignet.

In einem ersten Schritt 310 werden zur Übertragung der Daten in das Schieberegister 145 geladen. Zeitgleich wird in einem davon unabhängigen Schritt 320 ein Taktsignal variabler Taktfrequenz bereitgestellt. Die Taktfrequenz wird dabei vorzugsweisè abschnittsweise linear verändert, wozu ein abschnittsweise lineares Modulationssignal erzeugt an einen variablen Taktgenerator bereitgestellt werden kann.

In einem Schritt 330 werden die Daten in einem Schieberegister 145 mit der Taktfrequenz synchronisiert, so dass die Daten im Takt der Taktfrequenz serialisiert werden und die serialisierten Daten synchron zur Taktfrequenz in einem Leitungssignal bereitgestellt sind. In einem anschließenden Schritt 340 erfolgt ein Übertragen des bereitgestellten Leitungssignals über die Leitung 115.

Danach werden die Daten aus dem Leitungssignal in einem Schritt 350 dekodiert und schließlich in einem Schritt 360 bereitgestellt. Das Verfahren 300 verzweigt dann zurück zu Schritt 310 und kann erneut durchlaufen.

## Patentansprüche

1. Verfahren (300) zum Übertragen digitaler Daten eines Radarsensors (210) über eine Leitung (115), wobei das Verfahren (300) folgende Schritte aufweist:
- Bereitstellen (320) eines Taktsignals;
- Weiterleiten des Taktsignals an einen Ausgangsverstärker (250);
- Verstärkung des Taktsignals und Abstrahlung des verstärkten Signals über eine Sendeantenne (260) des Radarsensors (210);
- Empfang einer Reflexion des abgestrahlten Signals mittels einer Empfangsantenne (270) des Radarsensors (210);
- Verstärken der empfangenen Reflexion mittels eines Empfangsverstärkers (280);
- Bilden einer Differenz zwischen dem Taktsignal und dem verstärkten empfangenen Signal mittels eines Differenzbildners (290);
- Abtastung der durch den Differenzbildner (290) bereitgestellten Differenz mittels eines Analog-Digital-Wandlers (120);
- Übertragen (330) der digitalen Daten synchron zum Taktsignal über die Leitung (115);
wobei
- das Taktsignal eine Frequenz aufweist, die über die Zeit veränderlich ist.

2. Verfahren nach Anspruch 1, wobei das durch den Analog-Digital-Wandler (120) abgetastete Signal in einem Schieberegister (145) bereitgestellt wird und die im Schieberegister bereitgestellten digitalen Daten übertragen (330) werden.

3. Verfahren (300) nach Anspruch 1 oder 2, wobei die Frequenz abschnittweise linear verändert (320) wird.

4. Verfahren (300) nach einem der Ansprüche 1 bis 3, wobei die digitalen Daten binär codiert seriell übertragen (330) werden.

5. Radarsensor (210), aufweisend eine Modulationsquelle (220), einen modulierbaren Oszillator (230), einen Teiler, einen Ausgangsverstärker (250), eine Sendeantenne (260), eine Empfangsantenne (270), einen Empfangsverstärker (280), einen Differenzbildner (290) sowie einen Analog-Digital-Wandler (120), wobei der Radarsensor (210) eingerichtet ist:
- ein Taktsignal mittels der Modulationsquelle (220) und des modulierbaren Oszillators (230) bereitzustellen;
- das Taktsignal an einen Ausgangsverstärker (250) weiterzuleiten;
- das Taktsignal zu verstärken und das verstärkte Signal über eine Sendeantenne (260) abzustrahlen;
- eine Reflexion des abgestrahlten Signals mittels einer Empfangsantenne (270) zu empfangen;
- die empfangene Reflexion mittels eines Empfangsverstärkers (280) zu verstärken;
- eine Differenz zwischen dem Taktsignal und dem verstärkten empfangenen Signal mittels eines Differenzbildners (290) zu bilden;
- die durch den Differenzbildner (290) bereitgestellte Differenz mittels des Analog-Digital-Wandlers (120) abzutasten;
- die digitalen Daten mithilfe der Sendeeinrichtung (105) synchron zum Taktsignal zu übertragen, wobei das Taktsignal durch den Teiler bereitgestellt wird;
wobei das Taktsignal eine Frequenz aufweist, die über die Zeit veränderlich ist.

6. Radarsensor (210) nach Anspruch 5, ferner aufweisend ein Schieberegister (145), wobei der Radarsensor (210) eingerichtet ist, das durch den Analog-Digital-Wandler (120) abgetastete Signal im Schieberegister (145) bereitzustellen und die im Schieberegister (145) bereitgestellten digitalen Daten zu übertragen.

7. .Radarsensor nach einem der Ansprüche 5 oder 6, ferner aufweisend einen von der Modulationsquelle (220) und dem modellierbaren Oszillator (230) unabhängigen Taktgeber (130) zur Generierung eines Abtastsignals mit konstanter Frequenz zur Steuerung des Analog-Digital-Wandlers (120) vorgesehen ist.

8. System (100) zur Übertragung digitaler Daten, wobei das System (100) folgende Elemente umfasst:
- einen Radarsensor (210) nach einem der Ansprüche 5 bis 7;
- eine Empfangseinrichtung (110);
- eine Leitung (115) zur Übertragung eines Leitungssignals von der Sendeeinrichtung (105) zur Empfangseinrichtung (110);
- wobei die Sendeeinrichtung (105) eine Synchronisiereinrichtung (145) zur Bereitstellung des Leitungssignals auf der Basis einer Synchronisierung der Daten mit dem Taktsignal umfasst, und
- die Empfangseinrichtung (110) eine Decodiereinrichtung zur Decodierung der Daten aus dem über die Leitung (115) übertragenen Leitungssignal umfasst.

9. System (100) nach Anspruch 8, **dadurch gekennzeichnet, dass** die Leitung (115) nur einen physischen Kanal zum Übertragen von Informationen umfasst.

10. System (100) nach Anspruch 8 oder 9, **dadurch gekennzeichnet, dass** die Empfangseinrichtung (110) einen programmierbaren Mikrocomputer (175) umfasst.

## Claims

1. Method (300) for transmitting digital data from a radar sensor (210) via a line (115), wherein the method (300) has the following steps:
- providing (320) a clock signal;
- forwarding the clock signal to an output amplifier (250);
- amplifying the clock signal and emitting the amplified signal via a transmitting antenna (260) of the radar sensor (210);
- receiving a reflection of the emitted signal by means of a receiving antenna (270) of the radar sensor (210);
- amplifying the received reflection by means of a receiving amplifier (280);
- forming a difference between the clock signal and the amplified received signal by means of a subtractor (290);
- sampling the difference provided by the subtractor (290) by means of an analogue/digital converter (120);
- transmitting (330) the digital data in sync with the clock signal via the line (115);
wherein
- the clock signal has a frequency which is variable over time.

2. Method according to Claim 1, wherein the signal sampled by the analogue/digital converter (120) is provided in a shift register (145) and the digital data provided in the shift register are transmitted (330).

3. Method (300) according to Claim 1 or 2, wherein the frequency is linearly changed (320) in sections.

4. Method (300) according to one of Claims 1 to 3, wherein the digital data are serially transmitted (330) in a binary-coded manner.

5. Radar sensor (210) having a modulation source (220), a modulable oscillator (230), a splitter, an output amplifier (250), a transmitting antenna (260), a receiving antenna (270), a receiving amplifier (280), a subtractor (290) and an analogue/digital converter (120), wherein the radar sensor (210) is configured:
- to provide a clock signal by means of the modulation source (220) and the modulable oscillator (230);
- to forward the clock signal to an output amplifier (250);
- to amplify the clock signal and to emit the amplified signal via a transmitting antenna (260) ;
- to receive a reflection of the emitted signal by means of a receiving antenna (270);
- to amplify the received reflection by means of a receiving amplifier (280);
- to form a difference between the clock signal and the amplified received signal by means of a subtractor (290);
- to sample the difference provided by the subtractor (290) by means of the analogue/digital converter (120);
- to transmit the digital data in sync with the clock signal with the aid of the transmitting device (105), wherein the clock signal is provided by the splitter;
wherein the clock signal has a frequency which is variable over time.

6. Radar sensor (210) according to Claim 5, also having a shift register (145), wherein the radar sensor (210) is configured to provide the signal sampled by the analogue/digital converter (120) in the shift register (145) and to transmit the digital data provided in the shift register (145).

7. Radar sensor according to either of Claims 5 and 6, also having a clock generator (130) which is independent of the modulation source (220) and the modulable oscillator (230) and is intended to generate a sampling signal at a constant frequency for controlling the analogue/digital converter (120).

8. System (100) for transmitting digital data, wherein the system (100) comprises the following elements:
- a radar sensor (210) according to one of Claims 5 to 7;
- a receiving device (110);
- a line (115) for transmitting a line signal from the transmitting device (105) to the receiving device (110);
- wherein the transmitting device (105) comprises a synchronization device (145) for providing the line signal on the basis of a synchronization of the data with the clock signal, and
- the receiving device (110) comprises a decoding device for decoding the data from the line signal transmitted via the line (115).

9. System (100) according to Claim 8, **characterized in that** the line (115) comprises only one physical channel for transmitting information.

10. System (100) according to Claim 8 or 9, **characterized in that** the receiving device (110) comprises a programmable microcomputer (175).

## Revendications

1. Procédé (300) de transmission de données numériques d'un capteur radar (210) sur une ligne (115), le procédé (300) comportant les étapes suivantes :
- fournir (320) un signal d'horloge ;
- transmettre le signal d'horloge à un amplificateur de sortie (250) ;
- amplifier le signal d'horloge et rayonner le signal amplifié par le biais d'une antenne d'émission (260) du capteur radar (210) ;
- recevoir une réflexion du signal rayonné au moyen d'une antenne de réception (270) du capteur radar (210) ;
- amplifier la réflexion reçue au moyen d'un amplificateur de réception (280) ;
- former une différence entre le signal d'horloge et le signal reçu amplifié au moyen d'un générateur de différence (290) ;
- échantillonner la différence fournie par le générateur de différence (290) au moyen d'un convertisseur analogique-numérique (120) ;
- transmettre (330) les données numériques de manière synchrone avec le signal d'horloge sur la ligne (115) ;
- le signal d'horloge ayant une fréquence qui varie dans le temps.

2. Procédé selon la revendication 1, le signal échantillonné par le convertisseur analogique-numérique (120) étant fourni dans un registre à décalage (145) et les données numériques fournies dans le registre à décalage étant transmises (330).

3. Procédé (300) selon la revendication 1 ou 2, la fréquence étant modifiée linéairement (320) par portions.

4. Procédé (300) selon l'une des revendications 1 à 3, les données numériques étant transmises (330) en série sous forme codée binaire.

5. Capteur radar (210) comportant une source de modulation (220), un oscillateur modulable (230), un diviseur, un amplificateur de sortie (250), une antenne d'émission (260), une antenne de réception (270), un amplificateur de réception (280), un générateur de différence (290) et un convertisseur analogique/numérique (120), le capteur radar (210) étant conçu pour :
- fournir un signal d'horloge au moyen de la source de modulation (220) et de l'oscillateur modulable (230) ;
- transmettre le signal d'horloge à un amplificateur de sortie (250) ;
- amplifier le signal d'horloge et rayonner le signal amplifié par le biais d'une antenne d'émission (260) ;
- recevoir une réflexion du signal rayonné au moyen d'une antenne de réception (270) ;
- amplifier la réflexion reçue au moyen d'un amplificateur de réception (280) ;
- former une différence entre le signal d'horloge et le signal reçu amplifié au moyen d'un générateur de différence (290) ;
- échantillonner la différence fournie par le générateur de différence (290) au moyen du convertisseur analogique/numérique (120) ;
- transmettre les données numériques à l'aide du dispositif d'émission (105) de manière synchrone avec le signal d'horloge, le signal d'horloge étant fourni par le diviseur ;
le signal d'horloge ayant une fréquence qui varie dans le temps.

6. Capteur radar (210) selon la revendication 5, comprenant en outre un registre à décalage (145), le capteur radar (210) étant conçu pour fournir le signal échantillonné par le convertisseur analogique-numérique (120) dans le registre à décalage (145) et les données numériques fournies dans le registre à décalage (145) étant transmises.

7. Capteur radar selon l'une des revendications 5 ou 6, comportant en outre un générateur d'horloge (130) indépendant de la source de modulation (220) et de l'oscillateur modélisable (230) et destiné à générer un signal d'échantillonnage ayant une fréquence constante et destiné à commander le convertisseur analogique/numérique (120).

8. Système (100) de transmission de données numériques, le système (100) comprenant les éléments suivants :
- un capteur radar (210) selon l'une des revendications 5 à 7 ;
- un dispositif de réception (110) ;
- une ligne (115) destinée à la transmission d'un signal de ligne du dispositif d'émission (105) au dispositif de réception (110) ;
- le dispositif d'émission (105) comprenant un dispositif de synchronisation (145) destiné à fournir le signal de ligne sur la base d'une synchronisation des données avec le signal d'horloge, et
- le dispositif de réception (110) comprenant un dispositif de décodage destiné à décoder les données du signal de ligne transmis sur la ligne (115).

9. Système (100) selon la revendication 8, **caractérisé en ce que** la ligne (115) ne comporte qu'un seul canal physique destiné à la transmission d'informations.

10. Système (100) selon la revendication 8 ou 9, **caractérisé en ce que** le dispositif de réception (110) comprend un micro-ordinateur programmable (175).
